# EUROPÄISCHE PATENTSCHRIFT

(11) **EP 2 872 903 B1**
(45) Veröffentlichungstag und Bekanntmachung des Hinweises auf die Patenterteilung: **26.07.2023**
(21) Anmeldenummer: 12762239.7
(22) Anmeldetag: 04.09.2012
(51) Int. Cl.: G01R 15/06, G01R 19/25

(54) **MESSGERÄT, ANWENDUNG DES MESSGERÄTS UND VERFAHREN ZUM MESSEN EINER WECHSELSPANNUNG**
MEASURING DEVICE, USE OF THE MEASURING DEVICE, AND METHOD FOR MEASURING AN ALTERNATING VOLTAGE
APPAREIL DE MESURE, UTILISATION DE L'APPAREIL DE MESURE ET PROCÉDÉ POUR MESURER UNE TENSION ALTERNATIVE

(43) Veröffentlichungstag der Anmeldung: 20.05.2015
(73) Patentinhaber: Siemens Aktiengesellschaft, 80333 München (DE)
(72) Erfinder: DÖSCH, Peter, 90547 Stein (DE)
(74) Vertreter: Siemens Patent Attorneys
(86) Internationale Anmeldenummer: PCT/EP2012/067226
(87) Internationale Veröffentlichungsnummer: WO 2014/037032

(56) Entgegenhaltungen:
- WO-A1-2005/031374
- DE-B- 1 051 388
- US-A- 5 473 244

## Beschreibung

Die Erfindung betrifft ein Messgerät zum Messen einer Wechselspannung mittels eines an seinem ersten Anschluss mit der zu messenden Wechselspannung beaufschlagten Kondensators.

Insbesondere in elektrischen Mittel- und Hochspannungsanlagen werden Kondensatoren mit einer Abgriffmöglichkeit integriert bzw. es können parasitäre Kapazitäten abgegriffen werden. Die Kondensatoren bzw. vorhandenen Kapazitäten liegen beispielsweise an Kabelanschlussstellen oder in Durchführungen vor und können dazu verwendet werden, um zu messen, ob die betreffende elektrische Anlage spannungsfrei ist.

Darüber hinaus kann in Reihe zum Kondensator bzw. der vorhandenen parasitären Kapazität ein Unterspannungskondensator geschaltet werden. Auf diese Weise wird ein kapazitiver Spannungsteiler geschaffen, der als Signalquelle für eine Spannungsmessung dient. Diese kapazitive Signalquelle weist einen sehr hohen Innenwiderstand auf. Die Zuleitungskapazitäten und der Eingangswiderstand des Spannungsmessgeräts belasten die Signalquelle, was zu einer starken Verfälschung sowohl der Amplitude als auch der Phase der gemessenen Spannung führen kann. Eine Korrektur ist im Nachhinein nur möglich, wenn die Zuleitungskapazität und der Eingangswiderstand des Messgeräts genau bekannt sind. Ein weiterer Nachteil der Spannungsmessung mittels eines kapazitiven Teilers ist die hohe Störempfindlichkeit dieses Verfahrens.

Es ist aus dem europäischen Patent EP 1 664 804 B1 bekannt, Hochspannungsanlagen mit Hochspannungskoppelkondensatoren und Unterspannungskondensatoren zu versehen und so einen Spannungsgeber mit einem kapazitiven Teiler bereit zu stellen. Über einen hochohmigen Widerstand ist ein induktiver Spannungswandler an den kapazitiven Teiler angeschlossen. Diesem Spannungswandler ist ein Operationsverstärker zur Strom-Spannungs-Umwandlung nachgeordnet, dessen Ausgangsspannung in einem Analog-Digital-Wandler in digitale Messwerte überführt wird. Diese digitalen Messwerte werden einem Korrekturglied zugeführt, welches durch den Spannungsgeber bedingte bauartabhängige Störungen kompensieren kann.

Aus der Druckschrift DE1051388B ist ein gattungsgemäßes Messgerät bekannt, bei dem ein durch den Kondensator fließender Verschiebestrom gemessen wird.

Es ist die Aufgabe der Erfindung, ausgehend von dem bekannten Messgerät der DE1051388B ein Messgerät zur verbesserten, insbesondere relativ störunempfindlichen, Wechselspannungsmessung bereit zu stellen.

Diese Aufgabe wird erfindungsgemäß durch ein Messgerät zum Messen einer Spannung mittels eines an seinem ersten Anschluss mit der zu messenden Spannung beaufschlagten Kondensators, bei dem äußere Anschlussstellen des Messgeräts zum unmittelbaren Verbinden mit einem zweiten Anschluss des Kondensators und Erdpotential vorhanden sind, wobei das Spannungsmessgerät eine mit den äußeren Anschlussstellen verbundene elektronische Messeinrichtung mit kleinem Eingangswiderstand aufweist und der elektronischen Messeinrichtung eine Integrationseinrichtung nachgeordnet ist, gelöst.

Bei dem erfindungsgemäßen Messgerät wird ein durch den Kondensator fließender Verschiebestrom gemessen, der proportional zur zeitlichen Änderung der an dem Kondensator anliegenden Wechselspannung ist. Um aus diesen Verschiebestrom die zu messende Wechselspannung zu bestimmen, muss über die Zeit integriert werden. Dies geschieht mittels der Integrationseinrichtung, die beispielsweise ein integriertes elektronisches Bauteil oder eine auf einem Mikroprozessor ablaufende Software sein kann. Als Ausgangssignal stellt die Integrationseinrichtung ein Signal bereit, das der zu messenden Spannung proportional ist. Unter Berücksichtigung der Kapazität des Kondensators kann aus dem Signal der Momentanwert der zu messenden Spannung U bestimmt werden.

Das erfindungsgemäße Messgerät hat den Vorteil, dass auf einen Unterspannungskondensator als separates Bauelement verzichtet werden kann. Das Messgerät wird unmittelbar, also ohne Zwischenschaltung insbesondere eines großen Widerstands, an den Kondensator angeschlossen. Ein Verschiebestrom über den Kondensator wird also nicht wie bei Messgeräten mit ausgeprägtem Kapazitivem Teiler und entsprechenden eingangsseitig hochohmigen Messschaltungen stark verringert, sondern ist erfindungsgemäß über die elektronische Messeinrichtung mit kleinem Eingangswiderstand genau messbar.

Hieraus ergibt sich der weitere Vorteil, dass die Leitungskapazitäten und der Eingangswiderstand der elektronischen Messeinrichtung nicht - wie bei bekannten Messgeräten mit ausgeprägten kapazitiven Teilern - zu einer Verfälschung der Amplitude und der Phase der letztendlich gemessenen Wechselspannung führen. Vielmehr ist es hier der Fall, dass der Kondensator als Stromquelle mit einem hohen Innenwiderstand betrieben wird, die einen eingeprägten Strom liefert. Dieser eingeprägte Strom bzw. Verschiebestrom ist relativ störfest und kann mittels der erfindungsgemäßen Anordnung hochgenau gemessen werden.

In einer anderen vorteilhaften Ausführungsform des erfindungsgemäßen Messgeräts ist der Eingangswiderstand der elektronischen Messeinrichtung klein im Vergleich zur Impedanz einer Streukapazität, die sich zwischen dem zweiten Anschluss des Kondensators und Erdpotential ausbildet. Der Eingangswiderstand beträgt vorzugsweise weniger als 50 Ω, bevorzugt weniger als 25 Ω und noch mehr bevorzugt weniger als 10 Ω.

In einer weiteren vorteilhaften Ausführungsform des erfindungsgemäßen Messgeräts ist die elektronische Messeinrichtung über einen Übertrager an die äußeren Anschlussstellen angeschlossen. Der Übertrager trennt die elektronische Messeinrichtung galvanisch von dem Kondensator. Als Überträger kann beispielsweise ein Spulensystem aus zwei Spulen mit je 100 Wicklungen zu Einsatz kommen. Die galvanische Trennung des Kondensators von der elektronischen Messeinrichtung erlaubt eine potentialfreie, differenzielle Messung des Verschiebestromes. Insbesondere wird dadurch die elektronische Messeinrichtung vor elektromagnetischen Störungen geschützt.

Es weist die elektronische Messeinrichtung eingangsseitig einen Strom-Spannungswandler auf. Dies ist ein Vorteil, weil der Strom-Spannungswandler den Verschiebstrom in eine für die weitere Verarbeitung geeignete Spannung übersetzen kann.

Der Strom-Spannungswandler weist eine differenzielle Operationsverstärkerschaltung auf. Eine solche differenzielle Operationsverstärkerschaltung ist von Vorteil, weil sie besonders robust gegenüber auf dem Verschiebestrom überlagerten Gleichtaktstörungen ist.

Alternativ zu einer differenziellen Operationsverstärkerschaltung können auch eine unipolare Operationsverstärkerschaltung mit nur einem Operationsverstärker oder auch andere im Stand der Technik bekannte Verstärkerschaltungen verwendet werden.

Es weist die elektronische Messeinrichtung ausgangsseitig einen Analog-Digital-Wandler auf, dem eine digitale Integrationseinrichtung nachgeordnet ist. Dies ist vorteilhaft, weil ein Analog-Digital-Wandler die analoge Zwischenspannung des vorgeschalteten Strom-Spannungswandlers in ein digitales Messsignal umwandelt. Dieses digitale Messsignal wird dann auf besonders einfache Weise von der digitalen Integrationseinrichtung über die Zeit integriert, um die an dem Kondensator anliegenden Spannung zu erhalten.

Alternativ zu der digitalen Weiterverarbeitung des aus dem Strom-Spannungswandler kommenden Signals mittels eines Analog-Digital-Wandlers und einer digitalen Integrationseinrichtung kann auch eine analoge Integrationseinrichtung verwendet werden. Solchenfalls kann auf einen Analog-Digital-Wandler verzichtet werden.

In einer vorteilhaften Weiterbildung des erfindungsgemäßen Messgeräts ist der Integrationseinrichtung eine Umrechnungseinrichtung nachgeordnet. Diese berechnet aus dem von der Integrationseinrichtung bereitgestellten Spannungswert einen Spannungswert, der der an dem elektrischen Leiter anliegenden Spannung noch genauer entspricht. Die Berechnung kann beispielsweise eine Multiplikation mit einem Faktor umfassen, welche eine durch die Messelektronik bedingte und bekannte Verfälschung der gemessenen Spannung ausgleicht. Die Berechnung kann aber auch komplexere Korrekturen umfassen. Die Umrechnungseinrichtung kann ein elektronisches Bauteil oder eine auf einem Mikroprozessor ablaufende Software sein. Außerdem kann die Umrechnungseinrichtung mit der Integrationseinrichtung zu einem Bauteil zusammengefasst sein.

Weiterhin ist auch eine Anwendung des erfindungsgemäßen Messgeräts Gegenstand der Erfindung. Dabei wird eine der obenstehend beschriebenen Ausführungsformen des erfindungsgemäßen Messgeräts so verwendet, dass es unmittelbar an einen Kondensator bzw. eine parasitäre Kapazität angeschlossen ist, wobei der Kondensator bzw. die parasitäre Kapazität an seinem/ihrem ersten Anschluss mit einem die zu messende Spannung führenden elektrischen Leiter verbunden ist.

Diese Anwendung ist vorteilhaft, weil sie es ermöglicht, beliebige elektrische Leiter im Hinblick auf die an ihnen angelegte Spannung zu messen.

In einer bevorzugten Variante der Anwendung des erfindungsgemäßen Messgeräts ist der zweite Anschluss des Kondensators als eine den elektrischen Leiter umgebende Elektrode ausgebildet. Der Leiter fungiert in diesem Fall als Primärpol. Als Elektrode kann beispielsweise ein bereits vorhandener, vom Primärpol isolierter, metallischer Gegenstand genutzt werden, der eine isolierte Kapazität mit dem Primärpol bildet. Solchenfalls ist kein separates Bauelement als Kondensator erforderlich. Diese Ausführungsform ist von Vorteil, weil damit auch Spannungsmessungen an Hoch- und Höchstspannung möglich sind. An Hoch- und Höchstspannung können keine herkömmlichen Kondensatoren angeschlossen werden. Daher ist das erfindungsgemäße Messgerät auch dafür geeignet, beispielsweise die Spannung einer Hochspannungsleitung zu messen.

In einer anderen bevorzugten Variante der Anwendung des erfindungsgemäßen Messgeräts ist der Kondensator als separates Bauelement an den elektrischen Leiter angeschlossen. Diese Bauform ist von Vorteil, weil damit mit dem erfindungsgemäßen Messgerät auch Spannungsmessungen an beliebigen elektrischen Leitern wie z.B. Niederspannungsleitungen ermöglicht werden.

In einer besonders bevorzugten Variante der Anwendung des erfindungsgemäßen Messgeräts ist der elektrische Leiter Teil einer Mittelspannungsanlage oder einer Hochspannungsanlage.

Weiterhin ist ein Verfahren zum Messen einer Spannung mittels eines an seinem ersten Anschluss mit der zu messenden Spannung beaufschlagten Kondensators Gegenstand der Erfindung, bei dem an einem zweiten Anschluss des Kondensators ein Verschiebestrom in einer elektronischen Messeinrichtung mit niedrigem Eingangswiderstand gemessen wird; dieser Verschiebestrom wird mittels eines Strom-Spannungswandlers in eine Zwischenspannung überführt und über die Zeit integriert.

Es ergeben sich für das erfindungsgemäße Verfahren sinngemäß die gleichen Vorteile wie eingangs für das erfindungsgemäße Messgerät geschildert.

Eine weitere Ausführungsform des erfindungsgemäßen Verfahrens ergibt sich aus dem Anspruch 9. Auch hier ergeben sich für das erfindungsgemäße Verfahren sinngemäß die gleichen Vorteile wie eingangs für das erfindungsgemäße Messgerät geschildert.

Zur Erläuterung der Erfindung zeigt die
- Figur: eine Ausführungsform des erfindungsgemäßen Messgeräts zur Bestimmung einer Wechselspannung und eine beispielhafte Anwendung.

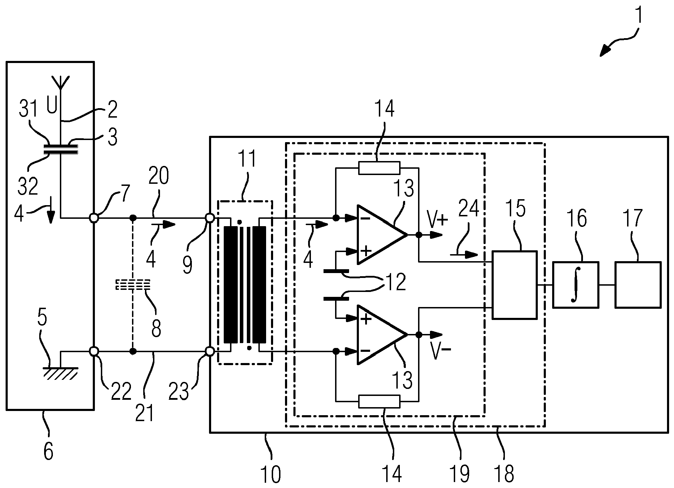

Die Figur zeigt eine Anwendung 1 eines Messgeräts 10 zur Bestimmung einer Spannung U einer elektrischen Anlage 6 mit einem Kondensator 3 in einer schematischen Darstellung. Die elektrische Anlage 6 weist einen die zu messende Spannung führenden elektrischen Leiter 2 auf, der mit dem Kondensator 3 verbunden ist. Dadurch ist der Kondensator 3 an seinem ersten Anschluss 31 mit der zu messenden Spannung U beaufschlagt. Der Kondensator 3 ist an seinem zweiten Anschluss 32 über eine Kontaktstelle 7 und einen Leiter 20 mit einer äußeren Anschlussstelle 9 des Messgeräts 10 verbunden.

Weiterhin weist die elektrische Anlage 6 eine Erdung 5 auf, welche über die Kontaktstelle 22 und einen Leiter 21 mit einer äußeren Anschlussstelle 23 des Messgeräts 10 verbunden ist. Zwischen den Kontaktstellen 7 und 22 bildet sich eine Streukapazität 8 aus.

Innerhalb des Messgeräts 10 befindet sich ein Übertrager 11, der eine Eingangsspule aufweist, welche an die äußeren Anschlussstellen 9 und 23 angeschlossen ist. Weiterhin weist der Übertrager 11 einen Eisenkern und eine weitere Spule auf, welche mit der elektronischen Messeinrichtung 18 innerhalb des Messgerätes 10 verbunden ist. Die beiden Spulen haben jeweils 100 Windungen.

Ausgangsseitig schließt sich an den Übertrager 11 eine elektronische Messeinrichtung 18 mit einer Strommesseinrichtung an. Diese weist einen Strom-Spannungswandler 19 und einen Analog-Digital-Wandler 15 auf. Der Strom-Spannungswandler 19 ist eine differenzielle Operationsverstärkerschaltung. Diese umfasst zwei Operationsverstärker 13. Über die jeweiligen Rückkopplungswiderstände 14 wird das Umsetzungsverhältnis bestimmt und die Spannung dem Analog-Digital-Wandler 15 zugeführt. Die beiden Operationsverstärker 13 sind mit je einem Massepotential 12 verbunden. An die elektronische Messeinrichtung 18 schließt sich eine digitale Integrationseinrichtung 16 an, an deren Ausgang 17 ein zu der zu messenden Spannung U proportionaler Wert abrufbar ist.

Im Folgenden soll nun die Funktionsweise der in der Figur dargestellten Anwendung 1 des Messgeräts 10 beschrieben werden. Durch den Kondensator 3 fließt ein geringer Verschiebestrom 4, der zum Messgerät 10 übertragen wird. In dem Messgerät 10 sorgt der Übertrager 11 dafür, dass die elektronische Messeinrichtung 18 innerhalb des Messgeräts 10 galvanisch von der elektrischen Schaltanlage 6 getrennt ist. Hierdurch ist die elektronische Messeinrichtung 18 vor starken elektromagnetischen Störungen geschützt. Durch die differenzielle Operationsverstärkerschaltung 19 wird der angelegte Verschiebestrom in eine für weitere Auswertungen geeignete Spannung 24 überführt. Diese Spannung 24 wird in dem Analog-/Digital-Wandler 15 in digitale Messwerte überführt. Diese digitalen Messwerte können nun in der Integrationseinrichtung 16 über die Zeit integriert werden; die integrierten Messwerte stehen am Ausgang 17 zur Verfügung. Sie sind den Momentanwerten der zu messenden Spannung U proportional. Unter Berücksichtigung der Kapazität des Kondensators 3 ergeben sich die korrekten Momentanwerte der Spannung U.

## Patentansprüche

1. Messgerät (10) zum Messen einer Wechselspannung (U) mittels eines an seinem ersten Anschluss (31) mit der zu messenden Spannung (U) beaufschlagten Kondensators (3),
- bei dem äußere Anschlussstellen (9,23) des Messgeräts (10) zum unmittelbaren Verbinden mit einem zweiten Anschluss (32) des Kondensators (3) und Erdpotential (5) vorhanden sind,
- wobei das Messgerät (10) ein Spannungsmessgerät (10) ist und das Spannungsmessgerät (10) eine mit den äußeren Anschlussstellen (9,23) verbundene elektronische Messeinrichtung (18) mit kleinem Eingangswiderstand aufweist, und
- **dadurch gekennzeichnet, dass**
- die elektronische Messeinrichtung (18) ausgangsseitig einen Analog-Digital-Wandler (15) aufweist, dem eine digitale Integrationseinrichtung (16) nachgeordnet ist, und dass
die elektronische Messeinrichtung (18) eingangsseitig einen Strom-Spannungswandler (19) aufweist, und dass der Strom-Spannungswandler (19) eine differenzielle Operationsverstärkerschaltung aufweist.

2. Messgerät (10) nach Anspruch 1, bei dem die elektronische Messeinrichtung (18) über einen Übertrager (11) an die äußeren Anschlussstellen (9,23) angeschlossen ist.

3. Messgerät (10) nach einem der vorhergehenden Ansprüche, bei dem der Integrationseinrichtung (16) eine Umrechnungseinrichtung nachgeordnet ist.

4. Anwendung (1) des Messgeräts (10) nach einem der vorhergehenden Ansprüche, **dadurch gekennzeichnet, dass** es unmittelbar an einen Kondensator (3) angeschlossen ist, der an seinem ersten Anschluss (31) mit einem die zu messende Spannung (U) führenden elektrischen Leiter (2) verbunden ist.

5. Anwendung (1) des Messgeräts (10) nach Anspruch 4, wobei der zweite Anschluss (31) des Kondensators (3) als eine den elektrischen Leiter (2) umgebende Elektrode ausgebildet ist.

6. Anwendung (1) des Messgeräts (10) nach Anspruch 4, wobei der Kondensator (3) als separates Bauelement an den elektrischen Leiter (2) angeschlossen ist.

7. Anwendung (1) des Messgeräts (10) nach Anspruch 5 oder 6, bei der der elektrische Leiter (2) Teil einer Mittelspannungsanlage oder einer Hochspannungsanlage (6) ist.

8. Verfahren zum Messen einer Spannung (U) mittels eines an seinem ersten Anschluss (31) mit der zu messenden Spannung (U) beaufschlagten Kondensators (3), bei dem
- an einem zweiten Anschluss (32) des Kondensators (3) ein Verschiebestrom (4) in einer elektronischen Messeinrichtung (18) mit kleinem Eingangswiderstand gemessen wird,
- wobei der Eingangswiderstand der elektronischen Messeinrichtung (18) klein ist im Vergleich zur Impedanz einer Streukapazität (8), die sich zwischen dem zweiten Anschluss (32) des Kondensators (3) und Erdpotential (5) ausbildet, und bei dem
- dieser Verschiebestrom (4) mittels eines Strom-Spannungswandlers (19) in eine Zwischenspannung (24) überführt und über die Zeit integriert wird,
**dadurch gekennzeichnet, dass**
- für die elektronische Messeinrichtung (18) ausgangsseitig ein Analog-Digital-Wandler (15) verwendet wird, dem eine digitale Integrationseinrichtung (16) nachgeordnet wird, und dass
- die elektronische Messeinrichtung (18) eingangsseitig
einen Strom-Spannungswandler (19) aufweist, und dass für den Strom-Spannungswandler (19) eine differenzielle Operationsverstärkerschaltung verwendet wird.

9. Verfahren nach Anspruch 8, bei dem die Zwischenspannung (24) analog gemessen und anschließend aus den analogen Messwerten digitale Messwerte erzeugt werden.

## Claims

1. Measuring device (10) for measuring an AC voltage (U) by way of a capacitor (3) that has the voltage (U) to be measured applied at its first connection (31),
- in which external connection points (9, 23) of the measuring device (10) are present for direct connection to a second connection (32) of the capacitor (3) and ground potential (5),
- wherein the measuring device (10) is a voltmeter (10) and the voltmeter (10) has an electronic measuring apparatus (18) with small input resistance connected to the external connection points (9, 23),
**characterized in that**
- the electronic measuring apparatus (18) has an analogue-to-digital converter (15) at output, downstream of which analogue-to-digital converter a digital integration apparatus (16) is arranged, and **in that**
- the electronic measuring apparatus (18) has a voltage-to-current converter (19) at input, and **in that** the voltage-to-current converter (19) has a differential operational amplifier circuit.

2. Measuring device (10) according to Claim 1, in which the electronic measuring apparatus (18) is connected to the external connection points (9, 23) via a transformer (11).

3. Measuring device (10) according to either of the preceding claims, in which the integration apparatus (16) is a conversion apparatus.

4. Use (1) of the measuring device (10) according to one of the preceding claims, **characterized in that** it is connected directly to a capacitor (3) that is connected, at its first connection (31), to an electrical conductor (2) carrying the voltage (U) to be measured.

5. Use (1) of the measuring device (10) according to Claim 4, wherein the second connection (31) of the capacitor (3) is designed as an electrode surrounding the electrical conductor (2) .

6. Use (1) of the measuring device (10) according to Claim 4, wherein the capacitor (3) is connected to the electrical conductor (2) as a separate component.

7. Use (1) of the measuring device (10) according to Claim 5 or 6, in which the electrical conductor (2) is part of a medium-voltage installation or of a high-voltage installation (6) .

8. Method for measuring a voltage (U) by way of a capacitor (3) that has the voltage (U) to be measured applied at its first connection (31), in which
- a displacement current (4) is measured in an electronic measuring apparatus (18) with small input resistance at a second connection (32) of the capacitor (3),
- wherein the input resistance of the electronic measuring apparatus (18) is small in comparison with the impedance of a stray capacitance (8) that is formed between the second connection (32) of the capacitor (3) and ground potential (5), and in which
- this displacement current (4) is converted into an intermediate voltage (24) by way of a current-to-voltage converter (19) and is integrated over time,
**characterized in that**
- an analogue-to-digital converter (15) is used at output for the electronic measuring apparatus (18), downstream of which analogue-to-digital converter a digital integration apparatus (16) is arranged, and **in that**
- the electronic measuring apparatus (18) has a current-to-voltage converter (19) at input, and **in that**
- a differential operational amplifier circuit is used for the current-to-voltage converter (19).

9. Method according to Claim 8, in which the intermediate voltage (24) is measured in analogue mode and then digital measured values are generated from the analogue measured values.

## Revendications

1. Appareil (10) de mesure pour la mesure d'une tension (U) alternative au moyen d'un condensateur (3), à la première borne (31) duquel est appliquée la tension (U) à mesurer,
- dans lequel il y a des points (9, 23) de connexion extérieurs de l'appareil (10) de mesure pour la liaison directe à une deuxième borne (32) du condensateur (3) et à un potentiel (5) de terre,
- dans lequel l'appareil (10) de mesure est un appareil (10) de mesure de la tension et l'appareil (10) de mesure de la tension a un dispositif (18) électronique de mesure à petite résistance d'entrée, qui est relié aux points (9, 23) de connexion extérieurs,
- **caractérisé en ce que**
- le dispositif (18) électronique de mesure a, du côté de la sortie, un convertisseur (15) analogique - numérique en aval duquel est monté un dispositif (16) numérique d'intégration,
et **en ce que**
le dispositif (18) électronique de mesure a, du côté de l'entrée, un convertisseur (19) courant - tension et **en ce que** le convertisseur (19) courant - tension a un circuit d'amplificateur opérationnel différentiel.

2. Appareil (10) de mesure suivant la revendication 1, dans lequel le dispositif (18) électronique de mesure est raccordé aux points (9, 23) de connexion extérieurs par un transformateur (11).

3. Appareil (10) de mesure suivant l'une des revendications précédentes, dans lequel un dispositif de recalculation est monté en aval du dispositif (16) d'intégration.

4. Application (1) de l'appareil (10) de mesure suivant l'une des revendications précédentes, **caractérisée en ce qu'**il est raccordé directement à un condensateur (3), qui est connecté à sa première borne (31) à un conducteur (2) électrique conduisant la tension (U) à mesurer.

5. Application (1) de l'appareil (10) de mesure suivant la revendication 4, dans laquelle la deuxième borne (31) du condensateur (3) est constituée sous la forme d'une électrode entourant le conducteur (2) électrique.

6. Application (1) de l'appareil (10) de mesure suivant la revendication 4, dans laquelle le condensateur (3) est raccordé en tant que composant distinct au conducteur (2) électrique.

7. Application (1) de l'appareil (10) de mesure suivant la revendication 5 ou 6, dans laquelle le conducteur (2) électrique fait partie d'une installation de moyenne tension ou d'une installation (6) de haute tension.

8. Procédé de mesure d'une tension (U) au moyen d'un condensateur (3), à la première borne (31) duquel est appliquée la tension (U) à mesurer,
- dans lequel on mesure, à une deuxième borne (32) du condensateur (3), un courant (4) de déplacement dans un dispositif (18) électronique de mesure à petite résistance d'entrée,
- dans lequel la résistance d'entrée du dispositif (18) électronique de mesure est petite par rapport à l'impédance d'une capacité (8) de fuite, qui se forme entre la deuxième borne (32) du condensateur (3) et le potentiel (5) de terre, et dans lequel
- on transforme ce courant (4) de déplacement au moyen d'un convertisseur (19) courant - tension en une tension (24) intermédiaire et on l'intègre en fonction du temps, **caractérisé en ce qu'**
- on utilise, pour le dispositif (18) électronique de mesure, du côté de la sortie, un convertisseur (15) analogique - numérique, en aval duquel on monte un dispositif (16) numérique d'intégration, et **en ce que**
- le dispositif (18) électronique de mesure a, du côté de l'entrée, un convertisseur (19) courant - tension, et **en ce qu'**on utilise, pour le convertisseur (19) de courant - tension, un circuit d'amplificateur opérationnel différentiel.

9. Procédé suivant la revendication 8, dans lequel on mesure analogiquement la tension (24) intermédiaire et on produit ensuite des valeurs de mesure numériques à partir des valeurs de mesure analogiques.
